# DEMANDE DE BREVET EUROPEEN

(11) **EP 1 675 168 A2**
(43) Date de publication de la demande: **28.06.2006**
(21) Numéro de dépôt: 05112520.1
(22) Date de dépôt: 20.12.2005
(51) Int. Cl.: H01L 21/60, H01L 23/485

(54) **Procédé et dispositif de positionnement de billes de connexion pour circuits intégrés**

(30) Priorité: 21.12.2004 FR 0453119
(71) Demandeur: ST MICROELECTRONICS S.A., 92120 Montrouge (FR)
(72) Inventeur: Boufnichel, Mohamed, 37100, Tours (FR); Hougron, Patrick, 37210, Parcay Meslay (FR); Jarry, Vincent, 37390 La Membrolle sur Choisille (FR)
(74) Mandataire: de Beaumont, Michel

(57) **Abrégé**

L'invention concerne la réalisation de bossages conducteurs sur une plaquette (1) de circuits intégrés, consistant à aspirer des billes conductrices (6) dans des cavités (82) d'un masque (8), à rapporter le masque portant les billes sur la plaquette de circuits intégrés, à fixer temporairement le masque et la plaquette ensemble, à couper l'aspiration et à soumettre l'ensemble masque et plaquette à un traitement thermique de fusion des billes.

## Description

### Domaine de l'invention

La présente invention concerne de façon générale la fabrication des circuits intégrés et, plus particulièrement, le placement de billes conductrices sur une plaquette de circuits intégrés pour réalisation de bossages conducteurs de raccordement électrique.

### Exposé de l'art antérieur

De plus en plus, le montage d'un circuit intégré sur un support avec reprise de contacts, que ce soit sur un circuit imprimé ou sur un autre circuit intégré, s'effectue par des bossages conducteurs (bumps) assurant les contacts entre le circuit intégré et son support. Ces bossages sont généralement portés par le circuit intégré à monter sur son support et sont réalisés par fusion de billes conductrices (généralement en un alliage d'étain et de plomb) positionnées sur des zones de réception ménagées dans une métallisation dédiée (UBM ou Under Bump Metalization) sur une face du circuit intégré.

La présente invention concerne plus particulièrement la réalisation de bossages conducteurs et notamment le placement de billes conductrices pour la réalisation de tels bossages.

Une première technique connue, dite avec flux, consiste à déposer au moyen d'un masque des empreintes d'un matériau adhésif sur les zones de réception des billes conductrices. Puis, les billes sont positionnées au droit de ces empreintes au moyen d'un deuxième masque et sont maintenues temporairement par l'adhésif permettant ainsi d'ôter le deuxième masque pour passage au four. Un inconvénient de cette technique est la présence de la couche d'adhésion temporaire qui est susceptible de former des microbulles d'air entre les billes et la plaquette engendrant par la suite des dégazages.

Une deuxième technique, dite sans flux, à laquelle s'applique plus particulièrement l'invention consiste à effectuer l'étape de fusion des billes conductrices alors que le masque de positionnement de ces billes est toujours présent sur la plaquette, évitant ainsi la colle de maintien temporaire.

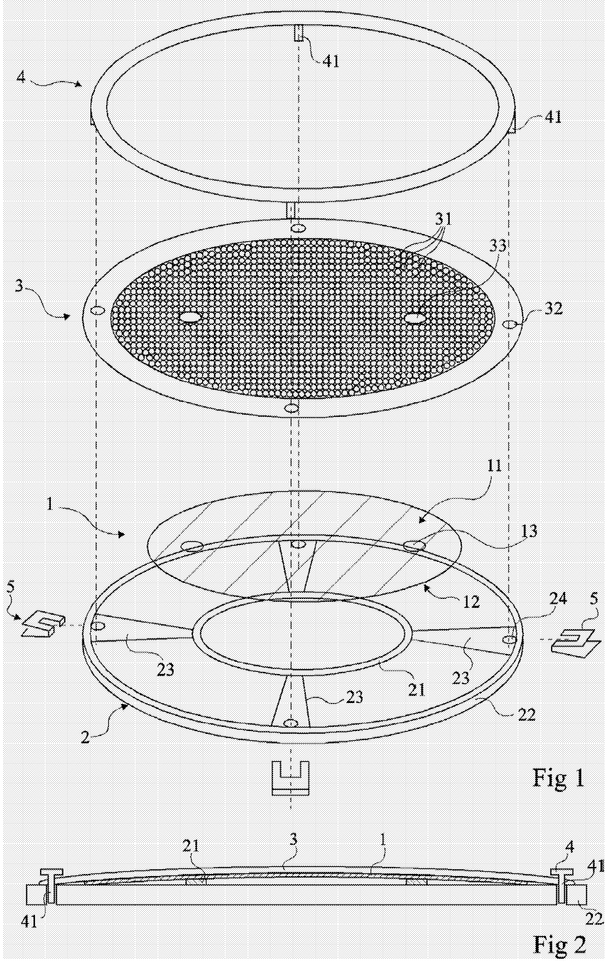

Les figures 1 et 2 représentent, respectivement vu en perspective éclatée et en coupe, un exemple classique d'outil de placement de billes conductrices dans un procédé de réalisation de bossages conducteurs sans flux.

Une plaquette 1 (par exemple, en silicium) portant des circuits intégrés actifs et/ou passifs (non représentés), et destinée à recevoir sur une face 11 des billes conductrices pour réalisation de bossages conducteurs, est placée sur un support 2 en inox. Ce support 2 est constitué d'une couronne interne 21 sur laquelle repose la face 12 de la plaquette 1 opposée à celle devant recevoir les billes, et d'une couronne externe 22 de diamètre supérieur au diamètre de la plaquette 1 à traiter. Les couronnes 21 et 22 sont reliées l'une à l'autre par des pattes radiales 23, régulièrement réparties entre les deux couronnes.

Un masque 3 en molybdène est rapporté sur la face 11 de la plaquette 1 et comporte des trous 31 à l'aplomb des zones de réception des billes prévues sur la plaquette 1. Pour des raisons de clarté, les dimensions ont été exagérées sur les figures et seuls quelques trous 31 ont été représentés. En pratique, le nombre de billes conductrices (donc de trous 31 dans le masque 3) est de plusieurs dizaines de milliers par plaquette (de l'ordre de 50 000 billes d'un diamètre d'environ 300 µm pour une plaquette d'une quinzaine de centimètres de diamètre - 6 pouces).

Un anneau 4 en inox est rapporté sur le masque 3 et comporte des pieds 41 qui traversent des orifices périphériques 32 du masque 3 et des orifices 24 des pattes 23 du support 2. Enfin, des clips 5 en inox sont disposés en périphérie pour maintenir les différents éléments entre eux.

Les orifices 32 (et éventuellement 24) sont d'un diamètre tel à permettre un jeu des pieds 41 au moins par rapport au masque 3. Ce jeu sert au positionnement précis du masque 3 par rapport à la plaquette 1 qui est effectué par des croix de centrage respectivement 33 et 13 réalisées dans le masque 3 et dans la plaquette 1. Le besoin de contact physique entre le masque 3 et la plaquette 1 afin d'éviter que des billes ne passent entre ces deux éléments impose une déformation de la plaquette 1 et du masque qui sont bombés (figure 2) sous l'effet du pincement périphérique et de la couronne interne 21.

Une fois l'outil assemblé avec une plaquette 1 et un masque 3 tel qu'illustré par la figure 2, il est utilisé jusqu'à la fin de la réalisation des bossages conducteurs.

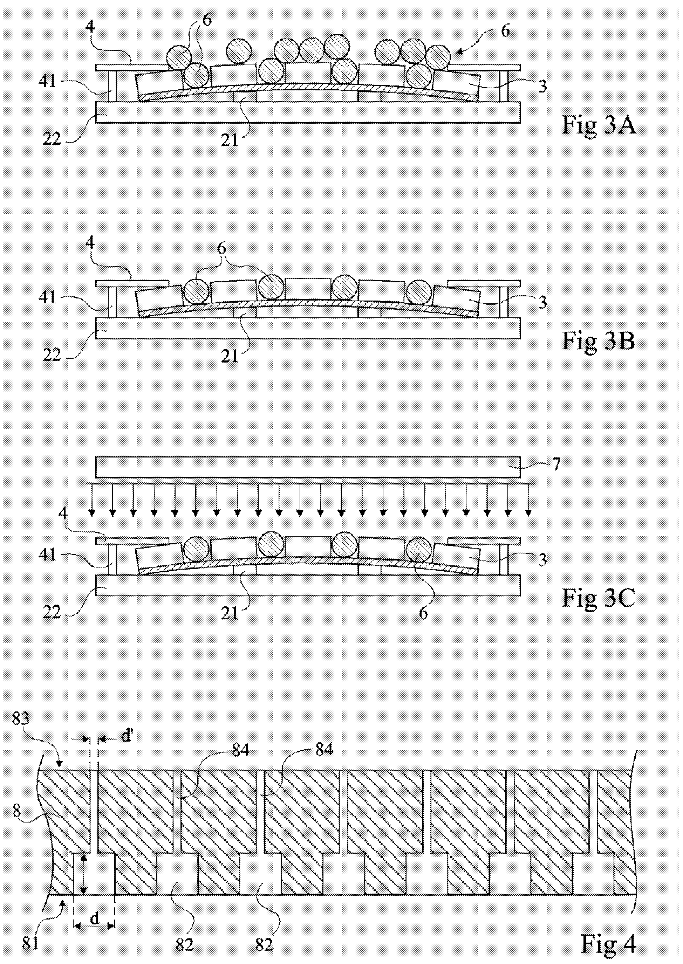

Les figures 3A, 3B et 3C illustrent, par des coupes très schématiques de l'outil de positionnement des billes, un exemple classique de procédé de réalisation de bossages conducteurs par positionnement de billes conductrices à travers un masque en molybdène 3 dans une technique sans flux.

Dans une première étape, des billes 6 en un matériau conducteur sont versées en vrac sur le masque 3 porté par l'outil décrit précédemment.

Puis, on impose des vibrations ou mouvements horizontaux à l'outil pour que des billes 6 se logent dans les trous 31 du masque 3 à raison d'une bille par trou, le diamètre des trous et l'épaisseur du masque étant choisis en fonction du diamètre des billes 6. Les billes en surplus sont éliminées de la surface du masque 3, par exemple en secouant l'ensemble. On obtient alors un ensemble tel qu'illustré par la figure 3B.

Cet ensemble est ensuite soumis à un traitement thermique (symbolisé par un élément radiant 7, figure 3C) pour faire fondre les billes 6 et obtenir les bossages conducteurs. Après refroidissement, l'outil est désassemblé et on obtient une plaquette (non représentée) pourvue de bossages conducteurs à des zones de reprise de contact. Cette plaquette est ensuite découpée pour individualiser les puces de circuits intégrés.

La technique de réalisation de bossages conducteurs sans flux au moyen d'un outil tel que décrit ci-dessus présente plusieurs inconvénients.

Un premier inconvénient est l'obligation d'imposer une courbure à la plaquette 1 pour assurer un contact entre sa surface supérieure (11, figure 1) et la surface inférieure du masque 3, qui engendre des contraintes mécaniques susceptibles d'endommager la plaquette.

Un autre inconvénient est la masse thermique de l'outil qui engendre des durées de traitement thermique importantes pour atteindre la température de fusion des billes.

Un autre inconvénient est la déformation du masque de molybdène pendant le traitement thermique qui, comme il présente un coefficient de dilatation différent de celui de la plaquette de silicium, est susceptible d'engendrer des défauts d'alignement des billes par rapport à leurs zones de réception respectives. Cet inconvénient limite les diamètres des plaquettes susceptibles d'être traitées par un tel procédé.

Un autre inconvénient de cette technique est qu'elle est en pratique limitée à des billes d'un diamètre de plusieurs centaines de micromètres (typiquement, 300 µm et plus). En effet, pour garantir la présence d'une seule bille par trou, l'épaisseur du masque correspond approximativement au diamètre des billes. Or, il n'est pas envisageable de diminuer encore l'épaisseur du masque pour des raisons de tenue mécanique.

### Résumé de l'invention

La présente invention vise à pallier tout ou partie des inconvénients des procédés et outils connus de formation de bossages conducteurs par une technique sans flux.

L'invention vise plus particulièrement à proposer une solution permettant la réalisation de bossages à partir de billes conductrices d'un diamètre inférieur à 300 µm, de préférence, inférieur ou égal à 100 µm.

L'invention vise également à proposer une solution compatible avec le dépôt de billes conductrices quel que soit le diamètre de la plaquette.

L'invention vise également à proposer une solution qui améliore le rendement thermique.

Pour atteindre tout ou partie de ces objets ainsi que d'autres, la présente invention prévoit un masque de positionnement de billes conductrices sur une plaquette de circuits intégrés, comportant, dans une première face, des cavités de réception individuelle des billes, chaque cavité communiquant avec une deuxième face du masque par un canal de section inférieure à la section de la cavité.

Selon un mode de réalisation de la présente invention, l'ouverture de chaque cavité dans la première face a une forme telle qu'une seule bille puisse s'engager avec jeu dans cette cavité.

Selon un mode de réalisation de la présente invention, la profondeur de chaque cavité est supérieure au diamètre des billes à laquelle est destiné le masque.

Selon un mode de réalisation de la présente invention, la section et la profondeur des cavités sont identiques et permettent l'engagement avec jeu d'une seule bille.

Selon un mode de réalisation de la présente invention, la section des cavités est inférieure à 100 µm.

Selon un mode de réalisation de la présente invention, le masque comporte en outre des ouvertures traversantes de section constante.

Selon un mode de réalisation de la présente invention, le masque est en silicium.

L'invention prévoit également un procédé de dépôt et de positionnement de billes conductrices sur une plaquette de circuits intégrés, caractérisé en ce qu'il consiste :
à aspirer des billes conductrices dans des cavités d'un masque ;
à rapporter le masque portant les billes sur la plaquette de circuits intégrés ; et
à fixer temporairement le masque et la plaquette ensemble.

Selon un mode de mise en oeuvre de la présente invention, l'aspiration est effectuée en plaçant la deuxième face du masque contre une plaque d'aspiration reliée, de préférence, à une pompe à vide.

L'invention prévoit également un procédé de réalisation de bossages conducteurs sur une plaquette de circuits intégrés, consistant :
à aspirer des billes conductrices dans des cavités d'un masque ;
à rapporter le masque portant les billes sur la plaquette de circuits intégrés ;
à fixer temporairement le masque et la plaquette ensemble ;
à couper l'aspiration ; et
à soumettre l'ensemble masque et plaquette à un traitement thermique de fusion des billes.

### Brève description des dessins

Ces objets, caractéristiques et avantages, ainsi que d'autres de la présente invention seront exposés en détail dans la description suivante de modes de mise en oeuvre et réalisation particuliers faite à titre non-limitatif en relation avec les figures jointes parmi lesquelles :
la figure 1 décrite précédemment est une vue schématique en perspective éclatée d'un outil classique de positionnement de billes conductrices ;
la figure 2 décrite précédemment est une vue schématique en coupe de l'outil de la figure 1 une fois monté ;
les figures 3A, 3B et 3C décrites précédemment illustrent un exemple classique de procédé de réalisation de bossages conducteurs au moyen de l'outil des figures 1 et 2 ;
la figure 4 représente un masque de dépôt de billes conductrices sur une plaquette de circuits intégrés selon un mode de réalisation de la présente invention ;
les figures 5A, 5B et 5C illustrent, par des vues schématiques en coupe, un mode de mise en oeuvre du procédé selon l'invention de réalisation de bossages conducteurs sur une plaquette à partir de billes conductrices ; et
la figure 6 est une vue partielle en coupe illustrant une variante de la présente invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Toujours pour des raisons de clarté, seuls les éléments et étapes qui sont utiles à la compréhension de l'invention ont été représentés aux figures et seront décrits par la suite. En particulier, la réalisation des zones conductrices de réception des bossages conducteurs sur la plaquette de circuits intégrés n'a pas été détaillée, l'invention étant compatible avec toute réalisation classique.

Selon un mode de réalisation de la présente invention, un masque de dépôt de billes conductrices, sur une plaquette portant des circuits intégrés actifs et/ou passifs, comporte des logements individuels ouverts sur une première face du masque et communiquant avec des canaux d'aspiration de section inférieure débouchant sur l'autre face du masque. Chaque logement est dimensionné pour être capable de contenir une bille entièrement et avec jeu.

La figure 4 représente, partiellement et en coupe, un masque 8 de dépôt et de positionnement de billes semicondutrices selon la présente invention.

L'invention sera décrite par la suite en relation avec un mode de réalisation préféré d'un masque 8 en silicium. Toutefois, elle s'applique plus généralement à tout matériau susceptible d'être usiné selon des diamètres différents dans son épaisseur et qui ne mouille pas aux matériaux constitutifs des billes à déposer (généralement, d'un alliage d'étain et de plomb ou d'étain et d'argent). De préférence, ce matériau est choisi pour avoir un coefficient de dilatation voisin des plaquettes à traiter.

Comme l'illustre la figure 4, des cavités 82 de réception chacune d'une bille sont formées depuis une première face 81 du masque 8 destiné à reposer contre la face (11, figure 1) de la plaquette de circuits intégrés. De préférence, les cavités 82 sont circulaires et ont une profondeur p identique à leur diamètre d. Chaque cavité 82 communique avec l'autre face 83 du masque 8 par un canal 84 d'aspiration. Chaque canal 84 est, par exemple, un trou circulaire percé dans le masque 8 et présente un diamètre d', inférieur au diamètre des billes à déposer, donc inférieur au diamètre d.

La réalisation d'une telle structure dans des masques constitués d'une plaque en silicium est particulièrement aisée. Par exemple, on pourra percer des trous traversants du diamètre d' dans la plaque en silicium au moyen d'un laser. Puis, graver par plasma les cavités 82.

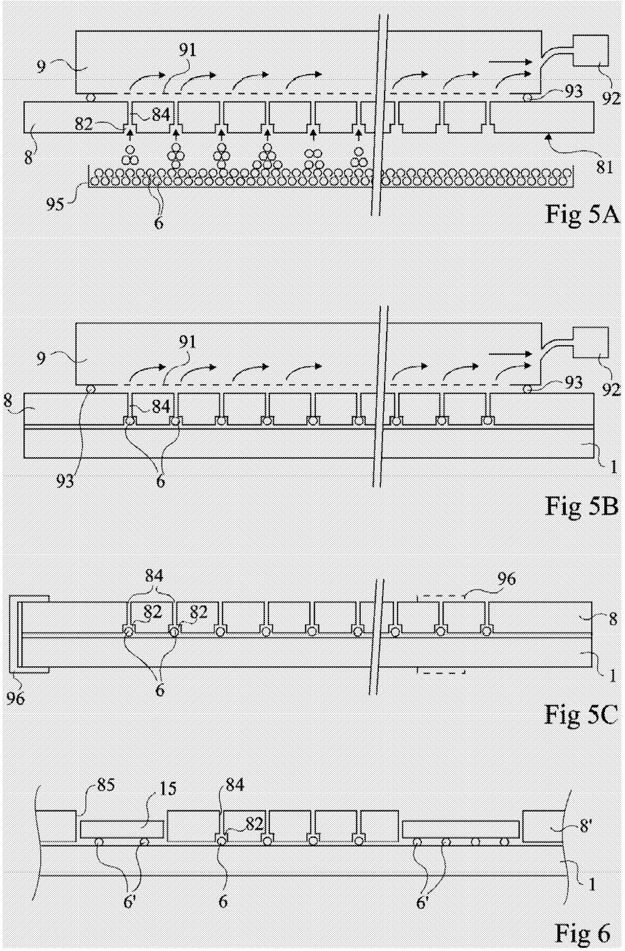

Les figures 5A, 5B et 5C illustrent, par des vues en coupe, un mode de mise en oeuvre du procédé de dépôt de billes conductrices sur une plaquette 1.

Comme l'illustre la figure 5A, un masque 8 comportant des cavités 82 et des canaux d'aspiration 84 répartis selon le motif des billes conductrices à positionner est associé à une plaque d'aspiration 9. Cette plaque comporte une face 91 pourvue d'orifices d'aspiration communiquant avec une pompe, par exemple une pompe à vide 92. Un joint d'étanchéité périphérique 93 est prévu entre le masque 8 et la plaque 9 qui sont maintenus ensemble, par exemple, par des pinces non représentées. L'ensemble est alors amené au dessus d'un bac 95 contenant des billes conductrices 6 en vrac.

Comme l'illustre la partie gauche de la figure 5A, les billes sont aspirées en direction des cavités 82 jusqu'à ce qu'une bille se loge dans chaque cavité disponible comme l'illustre la partie droite de la figure 5A. Une fois qu'une bille est logée au fond de sa cavité 82 par aspiration, elle bouche le canal 84 correspondant ce qui provoque, de façon automatique, la chute des autres billes qui avaient été attirées par le masque 8. Cet effet est amélioré en cas de revêtement anti-électrostatique de la face 81 du masque 8.

Comme l'illustre la figure 5B, l'ensemble masque 8 et plaque 9 est rapporté sur une plaquette 1 en silicium devant recevoir les billes. En variante, c'est la plaquette 1 qui est rapportée sur le masque 8. Le centrage du masque 8 par rapport à la plaquette 1 s'effectue, par exemple, de façon classique (croix 33 et 13, figure 1).

Comme l'illustre la figure 5C, la plaquette 1 est, une fois correctement positionnée, fixée temporairement au masque 8 au moyen de pinces 96, de préférence, régulièrement réparties autour de la plaquette. L'aspiration peut alors être arrêtée et la plaque 9 détachée du masque 8. Les billes 6 sont alors libérées et reposent sur la plaquette 1 en étant correctement positionnées au droit des zones de réception prévues.

La structure ainsi constituée peut alors être introduite dans un four pour faire fondre les billes 6 et obtenir les bossages conducteurs.

Après refroidissement, les pinces 96 sont ôtées pour libérer le masque 8 de la plaquette 1.

Un avantage de la présente invention est qu'il n'est plus nécessaire que le masque ait la même épaisseur que le diamètre des billes à déposer. Par conséquent, il est possible de déposer des billes de faibles diamètres (80 µm voire moins) avec un masque d'une épaisseur de plusieurs centaines de µm, donc d'une rigidité suffisante.

Un autre avantage de la présente invention est qu'avec des matériaux ayant des coefficients de dilatation identiques, on évite les risques de défaut de positionnement des billes. L'invention devient donc compatible avec le dépôt et le positionnement de billes conductrices sur des plaquettes de l'ordre d'une trentaine de centimètres (12 pouces), voire plus.

Un autre avantage de la présente invention est qu'elle évite le recours à un outil en inox pour maintenir le masque sur la plaquette, ce qui réduit la masse thermique de l'ensemble et améliore le rendement de cycle du four.

Un autre avantage de la présente invention est que le procédé de dépôt reste sans flux.

La figure 6 illustre, par une vue en coupe partielle, une variante de l'invention.

Selon cette variante, le masque 8', dans lequel ont été formées des cavités 82 et des canaux d'aspiration 84, comporte des ouvertures traversantes 85 dans des zones destinées à rapporter des puces de circuits intégrés 15 sur la plaquette 1. Il peut s'agir, par exemple, du report de circuits intégrés sur d'autres circuits (non représentés) réalisés dans la plaquette 1. Chaque circuit 15 porte sur sa face destinée à reposer sur la plaquette 1, des bossages conducteurs 6' réalisés de façon classique ou par la mise en oeuvre de l'invention sur les plaquettes ayant porté ces circuits 15.

Une telle variante permet de positionner à la fois les billes de formation de bossages conducteurs et les circuits intégrés devant être rapportés sur la plaquette 1 qui sont alors assemblés à celle-ci en même temps que la formation des bossages. Par la suite et de façon classique, les puces de circuit intégré sont individualisées de la plaquette 1 par découpe.

Les ouvertures 85 dans le masque 8' pourront, par exemple, être formées au moyen d'un laser tandis que les canaux 84 seront formés par laser ou par gravure plasma et les cavités 82 par gravure plasma.

Selon un autre mode de réalisation simplifié de l'invention, plus particulièrement destiné à des applications sur des plaquettes de diamètre relativement faible (de l'ordre d'une vingtaine de centimètres), et à des billes de diamètre relativement important (par exemple, de l'ordre de 300 µm), le masque 8 est en molybdène. Dans ce cas, les canaux 84 sont réalisés par laser tandis que les cavités sont réalisées, par exemple, par gravure électrochimique. Un tel mode de réalisation présente déjà l'avantage d'éviter grâce à l'utilisation d'un système de dépôt de billes par aspiration, le recours à un outil en inox, donc d'améliorer le rendement thermique. De plus, cela évite de nombreuses manipulations de l'outil pour le montage d'une plaquette et le dépôt des billes.

Bien entendu, la présente invention est susceptible de diverses variantes et modifications qui apparaîtront à l'homme de l'art. En particulier, d'autres méthodes de réalisation des cavités et canaux d'aspiration que celles indiquées à titre d'exemple pourront être envisagées pourvu d'être compatibles avec le matériau utilisé pour le masque et avec l'usinage d'une structure d'au moins deux sections différentes dans l'épaisseur du masque. De plus, bien que la réalisation de canaux d'un seul diamètre constitue un mode de réalisation préféré, il est envisageable de réaliser des canaux ayant des diamètres étagés entre les cavités 82 et la face arrière 83 du masque, notamment si cela est requis par les techniques d'usinage choisies.

## Revendications

1. Masque (8, 8') de positionnement de billes conductrices (6) sur une plaquette (1) de circuits intégrés, **caractérisé en ce qu'**il comporte, dans une première face (81), des cavités (82) de réception individuelle des billes, chaque cavité communiquant avec une deuxième face (83) du masque par un canal (84) de section inférieure à la section de la cavité et pouvant contenir une bille entièrement et avec jeu.

2. Masque selon la revendication 1, dans lequel l'ouverture de chaque cavité (82) dans la première face (81) a une forme telle qu'une seule bille (6) puisse s'engager avec jeu dans cette cavité.

3. Masque selon la revendication 1, dans lequel la profondeur (p) de chaque cavité (82) est supérieure au diamètre des billes (6) à laquelle est destiné le masque.

4. Masque selon la revendication 1, dans lequel la section (d) et la profondeur (p) des cavités (82) sont identiques et permettent l'engagement avec jeu d'une seule bille (6).

5. Masque selon la revendication 1, dans lequel la section des cavités (82) est inférieure à 100 µm.

6. Masque selon la revendication 1, comportant en outre des ouvertures (85) traversantes de section constante.

7. Masque selon la revendication 1, réalisé en silicium.

8. Procédé de dépôt et de positionnement de billes conductrices (6) sur une plaquette (1) de circuits intégrés, **caractérisé en ce qu'**il consiste :
à aspirer des billes conductrices dans des cavités (82) d'un masque (8, 8') conforme à l'une quelconque des revendications 1 à 7 ;
à rapporter le masque portant les billes sur la plaquette de circuits intégrés ; et
à fixer temporairement le masque et la plaquette ensemble.

9. Procédé selon la revendication 8, selon lequel l'aspiration est effectuée en plaçant la deuxième face (83) du masque (8) contre une plaque (9) d'aspiration reliée, de préférence, à une pompe à vide (92).

10. Procédé de réalisation de bossages conducteurs sur une plaquette (1) de circuits intégrés, **caractérisé en ce qu'**il consiste :
à aspirer des billes conductrices (6) dans des cavités (82) d'un masque (8, 8') conforme à l'une quelconque des revendications 1 à 7 ;
à rapporter le masque portant les billes sur la plaquette de circuits intégrés ;
à fixer temporairement le masque et la plaquette ensemble ;
à couper l'aspiration ; et
à soumettre l'ensemble masque et plaquette à un traitement thermique de fusion des billes.
